(19) Europäisches Patentamt
European Patent Office
Office européen des brevets

(11) **EP 1 365 418 B1**

(12) **FASCICULE DE BREVET EUROPEEN**

(45) Date de publication et mention
de la délivrance du brevet:
**31.01.2007 Bulletin 2007/05**

(51) Int Cl.:
***G11C 16/30*** (2006.01)

(21) Numéro de dépôt: **03358005.1**

(22) Date de dépôt: **17.04.2003**

(54) **Mémoire effacable et programmable électriquement comprenant un dispositif de gestion d'une tension d'alimentaire interne**

Elektrisch lösch- und programmierbare Speicher mit interner
Versorgungsspannungsregelungsvorrichtung

Electrically erasable and programmable memory with internal supply voltage controller

(84) Etats contractants désignés:
**DE FR GB IT**

(30) Priorité: **23.04.2002 FR 0205041**

(43) Date de publication de la demande:
**26.11.2003 Bulletin 2003/48**

(73) Titulaire: **STMicroelectronics S.A.**
**92120 Montrouge (FR)**

(72) Inventeurs:
• **Ganivet, Filipe**
**13770 Venelles (FR)**
• **La Rosa, Francesco**
**13790 Rousset (FR)**
• **Giovinazzi, Thierry**
**13100 Aix en Provence (FR)**

(74) Mandataire: **Marchand, André**
**OMNIPAT,**
**24 Place des Martyrs de la Résistance**
**13100 Aix-en-Provence (FR)**

(56) Documents cités:
**EP-A- 1 113 450          WO-A-01/65568**
**US-B1- 6 226 224**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne une mémoire effaçable et programmable électriquement, comprenant un plan mémoire comportant des cellules mémoire, et une ligne de distribution d'une tension d'alimentation interne reliée d'une part à une borne de réception d'une tension d'alimentation externe et d'autre part à un circuit survolteur.

La présente invention concerne plus particulièrement la gestion de la tension d'alimentation interne d'un telle mémoire, notamment pendant des phases de lecture de cellules mémoire.

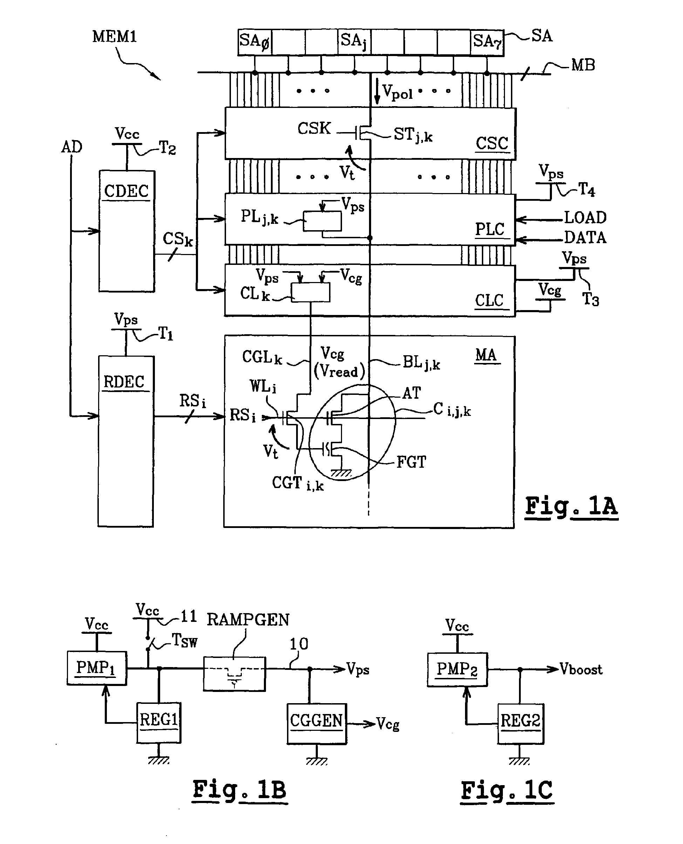

Un exemple d'architecture de mémoire effaçable et programmable électriquement est représenté schématiquement sur la figure 1A. La mémoire MEM1 représentée comprend un plan mémoire MA dans lequel des cellules mémoire $C_{i,j,k}$ sont reliées à des lignes de mot $WL_i$ et à des lignes de bit $BL_{j,k}$ agencées en colonnes, i étant un indice de ligne de mot, k un indice de colonne et j un indice de ligne de bit au sein d'une colonne.

Chaque cellule mémoire $C_{i,j,k}$ comprend un transistor à grille flottante FGT dont le drain est relié à une ligne de bit $BL_{j,k}$ par l'intermédiaire d'un transistor d'accès AT. La grille du transistor FGT est reliée à une ligne de contrôle de grille $CGL_k$ par l'intermédiaire d'un transistor de contrôle de grille $CGT_{i,k}$. La grille du transistor de contrôle de grille $CGT_{i,k}$ et la grille du transistor d'accès AT sont connectées à une ligne de mot WLi.

Pour assurer l'accès aux cellules mémoire en lecture et en écriture la mémoire comprend également un décodeur de ligne RDEC, un décodeur de colonne CDEC, un circuit de verrouillage de colonne CLC, un circuit de sélection de colonne CSC, un circuit de programmation PLC et un circuit de lecture SA.

Le circuit de lecture SA comprend des amplificateurs de lecture ("sense amplifiers"), par exemple huit amplificateurs SA0 à SA7 si le plan mémoire est composé de mots de huit bits. Chaque amplificateur $SA_j$ de rang j est relié, par l'intermédiaire d'un bus de multiplexage MB, à chaque ligne de bit $BL_{j,k}$ de même rang j présente dans chaque colonne du plan mémoire.

Le décodeur de ligne RDEC et le décodeur de colonne CDEC reçoivent respectivement les bits de poids fort et les bits de poids faible d'une adresse AD, et délivrent respectivement I signaux $RS_i$ de sélection de ligne et K signaux $CS_k$ de sélection de colonne. Après application d'une adresse AD, un signal de sélection de ligne $RS_i$ parmi les I signaux $RS_i$ est mis à 1 par le décodeur de ligne, tandis que les autres signaux $RS_i$ sont à 0. De même, un signal de sélection de colonne $CS_k$ parmi les K signaux $CS_k$ est mis à 1 par le décodeur de colonne tandis que les autres signaux $CS_k$ sont à 0.

Du point de vue électrique, un signal de sélection de ligne $RS_i$ à 1 présente un niveau de tension égal à une tension d'alimentation interne Vps appliquée sur une borne d'alimentation T1 du décodeur RDEC.

De même, un signal de sélection $CS_k$ à 1 présente un niveau de tension égal à une tension d'alimentation externe Vcc appliquée sur une borne d'alimentation T2 du décodeur CDEC.

Le circuit de sélection de colonne CSC comprend des transistors $ST_{j,k}$ de sélection de lignes de bit. Chaque transistor $ST_{j,k}$ est agencé en série sur une ligne de bit $BL_{j,k}$ et permet de connecter la ligne de bit à un amplificateur de lecture $SA_j$. Les transistors $ST_{j,k}$ présents sur des lignes de bit d'une même colonne sont pilotés par le signal $CS_k$ de sélection de la colonne considérée.

Le circuit de verrouillage de colonne CLC comprend des verrous de sélection de colonne $CL_k$ et reçoit sur une borne d'entrée une tension de contrôle de grille Vcg, chaque verrou $CL_k$ étant activé par un signal de sélection de colonne $CS_k$. Chaque verrou délivre la tension Vcg à la ligne de contrôle de grille $CGL_k$ de la colonne à laquelle il est affecté, lorsqu'il est activé par le signal $CS_k$ correspondant.

La tension Vps alimente électriquement les verrous de sélection de colonne $CL_k$ et est appliquée à cet effet sur une borne d'alimentation T3 du circuit CLC.

Le circuit de programmation PLC comprend des verrous de programmation $PL_{j,k}$ présentant chacun une sortie reliée à une ligne de bit $BL_{j,k}$. Les verrous $PL_{j,k}$ sont activés par les signaux de sélection $CS_k$, pour charger des données [DATA] à programmer, à raison d'un bit par verrou, sur réception d'un signal LORD.

La tension Vps alimente électriquement les verrous de programmation $PL_{j,k}$ et est appliquée à cet effet sur une borne d'alimentation T4 du circuit PLC.

La tension Vps est délivrée par une ligne de distribution 10 représentée en figure 1B, connectée aux bornes T1, T3, T4 des éléments décrits ci-dessus. La ligne de distribution 10 est reliée à une borne 11 d'alimentation de la mémoire par l'intermédiaire d'un transistor interrupteur Tsw qui est fermé (transistor passant) pendant les périodes de sélection de colonne, de chargement des verrous de programmation et de lecture. La tension Vps est alors sensiblement égale à la tension Vcc, en négligeant la chute de tension dans le transistor Tsw.

La ligne de distribution 10 est également reliée à la sortie d'un circuit survolteur PMP1, généralement une pompe de charge, alimenté par la tension Vcc et contrôlé par un régulateur REG1. Pendant des phases d'effacement et de programmation de cellules mémoire, l'interrupteur Tsw est ouvert (transistor bloqué) et la pompe de charge est activée. La pompe de charge délivre une haute tension Vpp, de l'ordre de 15 à 20 V, qui est appliquée progressivement sur la ligne 10 par un générateur de rampe RAMPGEN comprenant un transistor PMOS agencé en série sur la ligne 10. Ce transistor est représenté en traits pointillés car il est transparent du point de vue électrique (il n'introduit pratiquement pas de chute de tension dans la ligne 10) sauf pendant les périodes de génération de rampe.

La tension de contrôle de grille Vcg est délivrée par un circuit CGGEN alimenté par la tension Vps. Lorsque la mémoire est en phase lecture et que la tension Vps est égale à Vcc (Tsw passant), la tension Vcg délivrée par le circuit CGGEN est égale à une tension de lecture Vread. Lorsque la mémoire est en phase d'effacement et que la tension Vps est égale à la haute tension Vpp, la tension Vcg délivrée par le circuit CGGEN est égale à une haute tension d'effacement Verase. Enfin, lorsque la mémoire est en phase de programmation et que la tension Vps est égale à la haute tension Vpp, la tension Vcg délivrée par le circuit CGGEN est égale à 0 (masse).

On souhaite généralement qu'une telle mémoire présente des spécifications techniques qui soient assez larges et peu contraignantes pour l'utilisateur en ce qui concerne la tension d'alimentation externe Vcc, par exemple une fourchette de tolérance allant de 1,6 V à 5,6 V. Toutefois, il apparaît en pratique qu'une baisse de la tension Vcc dans les valeurs les plus basses de la fourchette de tolérance est susceptible d'entraîner un dysfonctionnement de la mémoire pendant des périodes de lecture de cellules mémoire.

Pour fixer les idées, supposons en se référant à la figure 1A qu'une cellule mémoire $C_{i,j,k}$ doive être lue par un amplificateur SAj. Un verrou de sélection de colonne $CL_k$ applique sur la ligne de contrôle de grille $CGL_k$ la tension Vcg. La tension Vcg est dans ce cas égale à Vread et doit se retrouver sans atténuation sur la grille du transistor à grille flottante FGT, par l'intermédiaire du transistor $CGT_{i,k}$. La tension Vread se situe entre la tension de seuil du transistor effacé et la tension de seuil du transistor programmé, et permet à l'amplificateur de lecture $SA_j$ de savoir si le transistor est passant (transistor effacé, correspondant à la lecture d'un 1) ou bloqué (transistor programmé, correspondant à la lecture d'un 0). Supposons que la tension Vread soit de l'ordre de 1,2 V, comme cela est généralement le cas, et que la fourchette de tolérance pour la tension Vcc soit 1,6 - 5,6 V.

Pour que la tension Vread atteigne sans atténuation la grille de contrôle du transistor FGT, la grille du transistor $CGT_{i,k}$ doit recevoir un signal de sélection $RS_i$ présentant un niveau de tension au moins égal à Vread + Vt, Vt étant la tension de seuil du transistor $CGT_{i,k}$. Le niveau de tension d'un signal de sélection $RS_i$ à 1 étant égal à la tension Vps appliquée sur la borne d'alimentation T1 du décodeur RDEC, la tension Vps doit être supérieure ou égale à un seuil Vmin1 tel que :

$$Vmin1 = Vread + Vt,$$

soit environ 2,2V dans l'exemple cité ci-dessus. Or, le seuil Vmin1 est supérieur aux valeurs les plus basses de la tension Vps figurant dans la fourchette de tolérance mentionnée ci-dessus.

Un problème similaire se rencontre sur la ligne de bit $BL_{j,k}$ pendant la lecture de la cellule. L'amplificateur de lecture $SA_j$ applique à la ligne de bit $BL_{j,k}$ une tension Vpol qui doit se retrouver sur le drain du transistor FGT après avoir traversé un transistor de sélection $ST_{j,k}$ et le transistor d'accès AT. Le transistor d'accès AT doit donc recevoir sur sa grille un signal de sélection $RS_i$ au moins égal à un seuil Vmin2 :

$$Vmin2 = Vpol + Vt,$$

Vt étant la tension de seuil du transistor d'accès.

De même, le transistor de sélection $ST_{j,k}$ doit recevoir sur sa grille un signal de sélection $CS_k$ au moins égal à Vmin2, de sorte que la tension Vcc appliquée sur le décodeur CDEC ne doit pas être inférieure à Vmin2.

En définitive, la prévision d'une fourchette de tolérance étendue pour la tension d'alimentation Vcc implique la prévision d'un moyen garantissant que la tension d'alimentation interne Vps ne chute pas en dessous des seuils Vmin1 et Vmin2 et que la tension Vcc appliquée au décodeur de colonne ne chute pas en dessous du deuil Vmin2.

La tension Vpol étant généralement inférieure à Vread, par exemple 1 V, le seuil Vmin2 est inférieur au seuil Vmin1. Le maintien d'une tension minimale Vmin1 sur les décodeurs RDEC et CDEC est donc une condition suffisante pour garantir une bonne polarisation des grilles du transistor d'accès AT et du transistor de sélection $ST_{j,k}$.

Une solution classique pour maintenir la tension d'alimentation interne Vps à un niveau suffisant est représentée en figure 1C. On prévoit un circuit survolteur, généralement une pompe de charge PMP2, qui délivre une tension régulée Vboost. La pompe de charge PMP2 est contrôlée par un régulateur REG2 et est placée en amont de la ligne de distribution 10, entre la borne d'alimentation 11 de la mémoire et le transistor interrupteur Tsw. La ligne 10 reçoit ainsi la tension Vboost à la place de la tension Vcc. La tension Vboost est également appliquée sur la borne T2 du décodeur CDEC, à la place de la tension Vcc.

Cette solution présente l'inconvénient que la pompe PMP2 consomme du courant en permanence, même lorsque cela n'est pas nécessaire, c'est-à-dire lorsque la tension Vcc est supérieure au seuil Vmin1.

Un objectif principal de la présente invention est de pallier cet inconvénient.

Un autre inconvénient de cette solution est qu'elle nécessite la prévision de deux pompes de charge, l'une pour délivrer la tension Vpp en mode effacement ou programmation et l'autre pour délivrer la tension Vboost en mode lecture.

Un autre objectif de la présente invention est de pallier cet autre inconvénient.

Un objectif de la présente invention est atteint par la prévision d'une mémoire effaçable et programmable électriquement, comprenant un plan mémoire comportant des cellules mémoire, une ligne de distribution d'une tension d'alimentation interne reliée d'une part à une borne de réception d'une tension d'alimentation externe et d'autre part à un circuit survolteur, une diode ou un circuit diode simulant le fonctionnement d'une diode reliant la ligne de distribution à la borne de réception, et des moyens pour déclencher le circuit survolteur lorsque la tension d'alimentation interne devient inférieure à un seuil déterminé, de manière à maintenir la tension d'alimentation interne au voisinage du seuil lorsque la tension d'alimentation externe est trop faible, au moins pendant la lecture de cellules mémoire, la diode ou le circuit diode étant alors bloqué.

Selon un mode de réalisation, le seuil déterminé est supérieur ou égal à la somme d'une tension de lecture de cellule mémoire et d'une tension de seuil de transistor MOS.

Selon un mode de réalisation, le seuil déterminé est supérieur ou égal à la somme d'une tension de polarisation de drain d'une cellule mémoire devant être lue et d'une tension de seuil de transistor MOS.

Selon un mode de réalisation, la mémoire comprend un circuit survolteur pour porter la tension d'alimentation interne à une haute tension d'effacement ou de programmation de cellules mémoire, pendant des phases d'effacement ou de programmation de cellules mémoire.

Selon un mode de réalisation, la mémoire comprend un seul circuit survolteur et un régulateur à deux modes de fonctionnement, pour : pendant des phases d'effacement ou de programmation de cellules mémoire, porter la tension d'alimentation interne à une haute tension d'effacement ou de programmation, et au moins pendant des phases de lecture de cellules mémoire, maintenir la tension d'alimentation interne au voisinage du seuil lorsque la tension d'alimentation externe est trop faible.

Selon un mode de réalisation, la mémoire comprend un décodeur de ligne comportant une borne d'alimentation connectée à la ligne de distribution.

Selon un mode de réalisation, la mémoire comprend des verrous de sélection de colonne et une borne d'alimentation des verrous de sélection de colonne connectée à la ligne de distribution.

Selon un mode de réalisation, la mémoire comprend des verrous de programmation et une borne d'alimentation des verrous de programmation connectée à la ligne de distribution.

Selon un mode de réalisation, la mémoire comprend un décodeur de colonne et une borne d'alimentation du décodeur de colonne qui est reliée d'une part à la ligne de distribution par l'intermédiaire d'un premier interrupteur qui est fermé au moins pendant des phases de lecture de cellules mémoire, et est reliée d'autre part à la borne de réception de la tension d'alimentation externe par l'intermédiaire d'un second interrupteur qui est fermé lorsque le premier interrupteur est ouvert.

Selon un mode de réalisation, le circuit diode comprend : un interrupteur d'alimentation à faible chute de tension série dont l'anode est reliée à la borne de réception de la tension d'alimentation externe et la cathode est reliée à la ligne de distribution, et des moyens de commande de l'interrupteur d'alimentation, agencés pour fermer automatiquement l'interrupteur d'alimentation lorsque la tension d'alimentation interne est supérieure à la tension d'alimentation externe.

Selon un mode de réalisation, les moyens de commande de l'interrupteur comprennent un circuit différentiel pour comparer la tension d'alimentation externe et la tension d'alimentation interne et délivrer un signal de commande de l'interrupteur d'alimentation, de manière à ouvrir l'interrupteur d'alimentation lorsque la tension d'alimentation interne est supérieure à la tension d'alimentation externe, et à maintenir l'interrupteur d'alimentation fermé lorsque la tension d'alimentation interne est sensiblement égale à la tension d'alimentation externe.

Selon un mode de réalisation, le circuit différentiel comprend deux branches agencées en miroir de courant, comprenant chacune au moins un transistor PMOS en série avec un transistor NMOS, une première branche étant polarisée par la tension d'alimentation externe et une seconde branche étant polarisée par la tension d'alimentation interne, le signal de commande de l'interrupteur d'alimentation étant prélevé sur le drain du transistor PMOS de la branche polarisée par la tension d'alimentation interne.

Selon un mode de réalisation, l'interrupteur d'alimentation est un transistor PMOS.

Selon un mode de réalisation, le circuit survolteur est une pompe de charge.

La présente invention concerne également un procédé de gestion d'une tension d'alimentation interne d'une mémoire effaçable et programmable électriquement, comprenant un plan mémoire comportant des cellules mémoire, et une ligne de distribution de la tension d'alimentation interne reliée d'une part à une borne de réception d'une tension d'alimentation externe et d'autre part à un circuit survolteur, comprenant une étape consistant à relier la ligne de distribution à la borne de réception par l'intermédiaire d'une diode ou d'un circuit diode simulant le fonctionnement d'une diode, et une étape d'activation du circuit survolteur lorsque la tension d'alimentation interne devient inférieure à un seuil déterminé, de manière à maintenir la tension d'alimentation interne au voisinage du seuil lorsque la tension d'alimentation externe est trop faible, au moins pendant la lecture de cellules mémoire, la diode ou le circuit diode étant alors bloqué.

Selon un mode de réalisation, le seuil déterminé est supérieur ou égal à la somme d'une tension de lecture de cellule mémoire et d'une tension de seuil de transistor MOS.

Selon un mode de réalisation, le seuil déterminé est supérieur ou égal à la somme d'une tension de polarisation de drain d'une cellule mémoire devant être lue et d'une tension de seuil de transistor MOS.

Selon un mode de réalisation, on prévoit un unique circuit survolteur pour : pendant des phases d'effacement ou de programmation de cellules mémoire, porter la tension d'alimentation interne à une haute tension d'effacement ou de programmation, et au moins pendant des phases de lecture de cellules mémoire, maintenir la tension d'alimentation interne au voisinage du seuil lorsque la tension d'alimentation externe est trop faible.

Selon un mode de réalisation, le procédé est appliqué à une mémoire comprenant un décodeur de colonne et une borne d'alimentation du décodeur de colonne, dans lequel on relie la borne d'alimentation du décodeur de colonne à la fois à la ligne de distribution, par l'intermédiaire d'un premier interrupteur qui est fermé au moins pendant des phases de lecture de cellules mémoire, et à la borne de réception de la tension d'alimentation externe, par l'intermédiaire d'un second interrupteur qui est fermé lorsque le premier interrupteur est ouvert.

Selon un mode de réalisation, on utilise un circuit diode comprenant un interrupteur d'alimentation à faible chute de tension série dont l'anode est reliée à la borne de réception de la tension d'alimentation externe et la cathode est reliée à la ligne de distribution, et des moyens de commande de l'interrupteur d'alimentation, agencés pour fermer automatiquement l'interrupteur d'alimentation lorsque la tension d'alimentation interne est supérieure à la tension d'alimentation externe.

Ces objets, caractéristiques et avantages ainsi que d'autres de la présente invention seront exposés plus en détail dans la description suivante d'une mémoire comprenant un dispositif de gestion d'alimentation selon l'invention, faite à titre non limitatif en relation avec les figures jointes parmi lesquelles :

- la figure 1A précédemment décrite représente un exemple classique d'architecture de mémoire effaçable et programmable électriquement,
- la figure 1B représente des moyens classiques de gestion de la tension d'alimentation interne de la mémoire de la figure 1A,
- la figure 1C représente un moyen supplémentaire classique de gestion de la tension d'alimentation interne de la mémoire de la figure 1A,
- la figure 2 représente schématiquement une mémoire effaçable et programmable électriquement comprenant un dispositif de gestion d'alimentation selon l'invention, représentée sous forme de blocs,
- la figure 3 est un schéma plus détaillé du dispositif de gestion d'alimentation selon l'invention,
- les figures 4A et 4B sont des courbes représentant respectivement une tension d'alimentation externe, et une tension d'alimentation interne délivrée par le dispositif de gestion d'alimentation selon l'invention,
- la figure 5 représente un exemple de réalisation d'un élément représenté sous forme de bloc en figure 3, et
- la figure 6 est un schéma électrique illustrant une étape de lecture d'une cellule mémoire dans la mémoire de la figure 2.

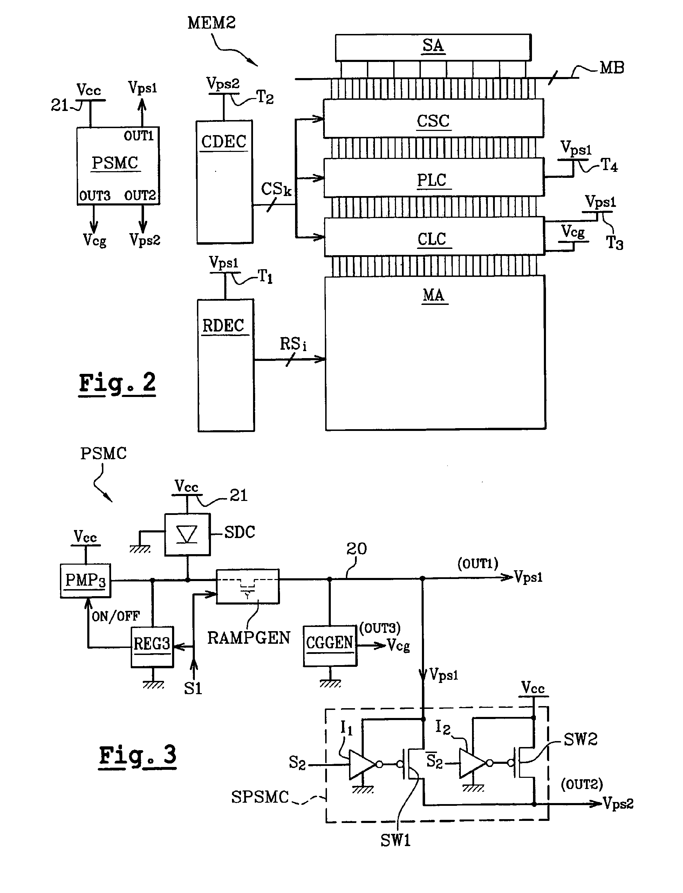

La figure 2 représente une mémoire effaçable et programmable électriquement MEM2 comprenant un circuit de gestion d'alimentation PSMC selon l'invention.

Le circuit PSMC comprend une entrée reliée à une borne d'alimentation 21 de la mémoire, sur laquelle est appliquée une tension d'alimentation externe Vcc. Il présente une sortie OUT1 reliée à une ligne de distribution 20, qui délivre sur cette ligne 20 une tension d'alimentation interne Vps1. Le circuit PSMC comprend également une sortie OUT2 délivrant une tension Vps2 et une sortie OUT3 délivrant une tension de contrôle de grille Vcg.

La mémoire MEM2 présente d'autre part une architecture classique et l'on y retrouve les éléments déjà décrits ci-dessus, désignés par les mêmes références, à savoir le plan mémoire MA, le décodeur de ligne RDEC, le décodeur de colonne CDEC, le circuit de verrouillage de colonne CLC, le circuit de sélection de colonne CSC, le circuit de programmation PLC, le circuit de lecture SA et le bus de multiplexage MB.

Le décodeur de ligne RDEC reçoit sur sa borne d'alimentation T1 la tension Vps1, via la ligne 20. La tension Vps1 détermine ainsi le niveau de tension d'un signal de sélection de ligne RSi à 1.

Le décodeur de colonne CDEC reçoit sur sa borne d'alimentation T2 la tension Vps2 délivrée par la sortie OUT2 du circuit PSMC. La tension Vps2 détermine ainsi le niveau de tension d'un signal de sélection de colonne $CS_k$ à 1.

La tension Vps1 est également appliquée sur la borne d'alimentation T3 du circuit de verrouillage de colonne CLC ainsi que sur la borne d'alimentation T4 du circuit PLC, qui sont connectées à la ligne 20. Le circuit CLC comprend des verrous de sélection de colonne (non représentés, cf. fig. 1A) et reçoit également sur une autre borne la tension Vcg délivrée par la sortie OUT3 du circuit PSMC. La tension Vcg est destinée à être appliquée aux grilles des transistors à grille flottante du plan mémoire par l'intermédiaire des verrous de sélection de colonne et des lignes de contrôle de grille (non représentés, cf. fig. 1A).

La figure 3 représente sous forme de blocs l'architecture du circuit PSMC. On distingue tout d'abord un circuit survolteur, ici une pompe de charge PMP3, dont la sortie est connectée à la ligne de distribution 20. La pompe de charge PMP3 est contrôlée par un régulateur REG3 qui lui applique un signal ON/OFF de démarrage ou d'arrêt. Le circuit PSMC comprend également un circuit superdiode SDC comprenant une entrée ou anode connectée à la borne 21, recevant la tension Vcc, et une sortie ou cathode connectée à la ligne de distribution 20. Le circuit SDC est appelé circuit superdiode car il simule le fonctionnent d'une diode idéale ayant une tension de seuil nulle. Le circuit SDC est ainsi passant lorsque la tension Vcc est sensiblement égale par valeurs supérieures à la tension Vps1, et bloqué lorsque la tension Vcc est inférieure à la tension Vps1.

La tension Vps2 est délivrée par un circuit secondaire SPSMC présent dans le circuit PSMC. La sortie du circuit SPSMC forme la sortie OUT2 du circuit PSMC, et est ainsi connectée à la borne T2 du décodeur de colonne CDEC. Le circuit SPSMC comprend un interrupteur SW1 reliant la ligne 20 à la sortie OUT2, ainsi qu'un interrupteur SW2 dont une borne reçoit la tension d'alimentation externe Vcc et dont l'autre borne est connectée à la sortie OUT2. Les interrupteurs sont pilotés par des signaux opposés S2 et /S2, l'interrupteur SW1 étant fermé lorsque l'interrupteur SW2 est ouvert et vice-versa. Comme représenté, les interrupteurs sont de préférence des transistors PMOS, pour que la chute de tension aux bornes de chaque interrupteur soit nulle ou presque nulle. Les signaux S2 et /S2 sont appliqués sur les grilles des transistors MOS par l'intermédiaire de portes inverseuses I1 et I2, alimentées respectivement par la tension Vps1 et la tension Vcc et assurant l'adaptation en tension des signaux S2 et /S2. La tension Vps2 délivrée par la sortie OUT2 est ainsi égale à la tension Vps1 ou à la tension Vcc, selon la valeur du signal S2, en négligeant la chute de tension dans les interrupteurs SW1, SW2.

Enfin, la tension de contrôle de grille Vcg est délivrée par un circuit CGGEN en soi classique, dont la sortie forme la sortie OUT3 du circuit PSMC.

Le régulateur REG3 présente ici deux modes de fonctionnement, sélectionnés au moyen d'un signal S1. Dans le premier mode de fonctionnement, par exemple lorsque S1=0, le régulateur REG3 surveille la tension Vps1 présente sur la ligne 20 et active la pompe de charge PMP3 quand la tension Vps1 devient inférieure à un seuil Vmin3. Le seuil Vmin3 est choisi au moins égal sinon supérieur au plus grand des seuils Vmin1 et Vmin2 décrits ci-dessus, en dessous desquels la tension Vps1 serait insuffisante pour garantir le bon déroulement du processus de lecture de cellules mémoire.

Dans le second mode de fonctionnement, le régulateur REG3 contrôle la pompe de charge pour qu'elle délivre une haute tension Vpp. La tension Vpp est appliquée progressivement par un circuit RAMPGEN qui est activé par le passage à 1 du signal Si. Le circuit RAMPGEN comprend par exemple un transistor de contrôle PMOS agencé en série sur la ligne 20, représenté en traits pointillés et pouvant être considéré comme transparent du point de vue électrique en dehors des périodes de génération de rampe.

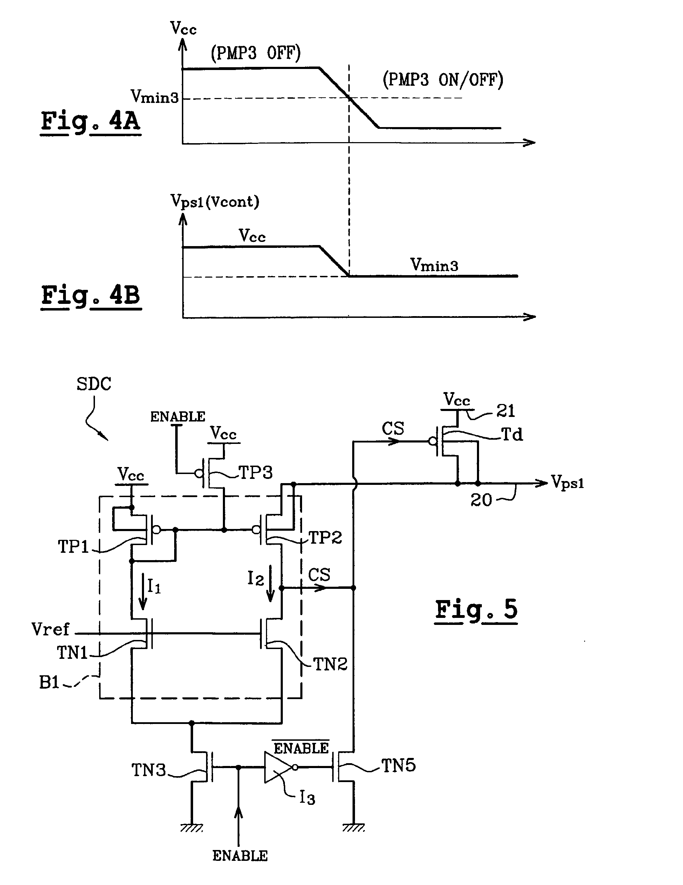

Le premier mode de fonctionnement du circuit PSMC est illustré sur les figures 4A et 4B, qui représentent respectivement la tension Vcc et la tension Vps1.

Lorsque la tension Vcc est supérieure à Vmin3, le régulateur REG3 applique le signal OFF à la pompe de charge PMP3 qui est inactive (PMP3 OFF), et le circuit superdiode SDC est passant. La tension Vps1 est ainsi sensiblement égale à la tension Vcc, en négligeant la chute de tension dans le circuit SDC, et la pompe de charge PMP3 ne consomme avantageusement aucun courant.

Lorsque la tension Vcc chute en dessous de Vmin3, le régulateur active la pompe de charge PMP3 en appliquant le signal ON. La pompe de charge délivre alors une tension Vps1 qui est régulée au voisinage de la tension Vmin3, par des arrêts et des redémarrages successifs de la pompe de charge (PMP3 ON/OFF) sous le contrôle du régulateur REG3.

Le circuit SPSMC permet de ne pas appliquer la tension Vps1 au décodeur de colonne CDEC pendant les périodes d'effacement et programmation, quand la tension Vps1 est égale à la haute tension Vpp. Le signal S2 est alors mis à 0 et le décodeur de colonne est alimenté par la tension Vcc via l'interrupteur SW2. De préférence, le signal S2 est mis à 1 uniquement pendant les périodes de lecture effective de cellules mémoire, lorsque la tension Vps2 doit être contrôlée afin de garantir le bon déroulement du processus de lecture. Le signal S2 peut être laissé à 0 pendant des périodes de chargement de verrous de programmation, pendant des périodes de sélection de colonnes, etc..

Le tableau 1 ci-après résume le fonctionnement du circuit PSMC. Vcont désigne la valeur contrôlée de la tension Vps1 en dehors des périodes d'effacement et programmation, lorsque la tension Vps1 est maintenue au-dessus du seuil Vmin3 comme illustré par la figure 4B.

**Tableau 1 :**

|  | S1 | S2 | Vcg | Vps1 | Vps2 |
|---|---|---|---|---|---|
| **Etapes préparatoires pour l'écriture d'un mot :** |  |  |  |  |  |
| Application d'une adresse, sélection d'une ligne et d'une colonne, chargement d'un mot dans des verrous de programmation... | 0 | 0 | 0 | Vcont | Vcc |

(suite)

| Ecriture d'un mot : | | | | | |
|---|---|---|---|---|---|
| Effacement de la ligne de mot | **1** | 0 | Verase | **Vpp** | Vcc |
| Programmation du mot | **1** | 0 | 0 | **Vpp** | Vcc |
| Etapes préparatoires pour la lecture d'un mot : | | | | | |
| Application d'une adresse, sélection d'une ligne et d'une colonne, activation d'un verrou de sélection de colonne... | 0 | 0 | 0 | Vcont | Vcc |
| Lecture d'un mot | | | | | |
| Activation des amplificateurs de lecture et application de la tension de lecture Vread aux cellules | 0 | **1** | Vread | Vcont | **Vcont** |

Pendant la lecture de cellules mémoire, la tension Vcg est égale à une tension de lecture Vread qui est une fraction de la tension Vps1. Pendant des phases d'effacement(Vps1=Vpp), la tension Vcg est égale à une haute tension Verase qui est une fraction de la tension Vpp (Verase étant en pratique de l'ordre de Vpp moins une chute de tension dans des transistors NMOS). Pendant des phases de programmation, la tension Vcg délivrée par le circuit CGGEN est égale à 0 (masse).

La figure 5 représente un mode de réalisation du circuit superdiode SDC. Le circuit SDC comprend essentiellement un transistor Td de type PMOS et un bloc de contrôle B1 délivrant un signal de contrôle CS appliqué sur la grille du transistor Td. La source du transistor Td est reliée à la borne d'alimentation 21, sur laquelle se trouve la tension Vcc. Le drain et le substrat ("bulk") du transistor Tp sont reliés à la ligne de distribution 20, sur laquelle se trouve la tension Vps1. Lorsqu'il est passant, le transistor Td simule la fonction superdiode décrite plus haut car la chute de tension série à ses bornes est très faible et est due uniquement à sa résistance source-drain dans le sens passant (Rdson). Le bloc de contrôle B1 bloque le transistor Td quand la tension Vps1 est supérieure à la tension Vcc, de manière à simuler le blocage d'une diode polarisée en inverse.

Dans ce qui suit, les transistors désignés TPn sont des transistors PMOS et les transistors désignés TNn sont des transistors NMOS, n étant un nombre.

Le bloc B1 comprend deux branches agencées en miroir de courant, la première comprenant un transistor TP1 en série avec un transistor TN1, la deuxième comprenant un transistor TP2 en série avec un transistor TN2. La source S et le substrat du transistor TP1 reçoivent la tension Vcc. La grille G du transistor TP1 est connectée au drain D de ce transistor ainsi qu'à la grille du transistor TP2. Le drain D du transistor TP1 est connecté au drain du transistor TN1, dont la source est reliée à la masse. La source S et le substrat du transistor TP2 sont connectés à la ligne de distribution 20 et reçoivent ainsi la tension Vps1. Le drain du transistor TP2 est connecté au drain du transistor TN2 dont la source est reliée à la masse. Les grilles des transistors TN1 et TN2 sont polarisées par une tension Vref sensiblement constante qui impose des courants I1, I2 présumés égaux dans les deux branches. La tension Vref est sensiblement égale à la tension de seuil des transistors TN1, TN2 de manière que ceux-ci fonctionnent en mode saturé (et soient de ce fait équivalents à des générateurs de courant). Le signal de contrôle CS est prélevé au noeud de connexion des drains des transistors TP2 et TN2.

Le circuit SDC comprend optionnellement un transistor TP3 piloté par un signal ENABLE, qui relie les grilles des transistors TP1, TP2 à la tension Vcc, et un transistor TN3 piloté par le signal ENABLE, qui relie les sources des transistors TN1, TN2 à la masse. Toujours de façon optionnelle, le noeud de sortie du bloc B1 délivrant le signal CS est relié à la masse par l'intermédiaire d'un transistor TN5 ayant sa grille pilotée par un signal inversé /ENABLE délivré par une porte I3.

Lorsque le signal ENABLE est à 0, le transistor TP3 est passant et le transistor TN3 est bloqué. Les transistors TP1 et TP2 reçoivent la tension Vcc sur leurs grilles et sont bloqués. Le transistor TN5 est passant et force le signal CS à 0, de sorte que le transistor Td est passant. La tension Vps1 n'est pas contrôlée et est en permanence égale à Vcc.

Le circuit SDC est actif quand le signal ENABLE est à 1 (Vcc). Le bloc B1 fonctionne alors comme une sorte d'amplificateur différentiel comparant les tensions de source des transistors TP1 et TP2, soit les tension Vcc et Vps1. Si la pompe de charge n'est pas activée par le régulateur et que la tension Vps1 sur la ligne 20 est sensiblement égale à Vcc par valeurs inférieures, la tension de grille du transistor(TP2 est égale à Vcc-Vt, Vt étant la tension de seuil de TP2, tandis que la source du transistor TP2 reçoit une tension sensiblement égale à Vcc par valeurs inférieures, soit Vcc-$\varepsilon$. La tension source-grille Vsg du transistor TP2 est égale à Vt-$\varepsilon$ et est sensiblement inférieure à Vt, de sorte que le transistor TP2 est bloqué. Le transistor TN2 étant passant, le signal CS tend vers 0 et maintient le transistor Td dans l'état passant. Quand le régulateur déclenche la pompe de charge (tension Vcc inférieure au seuil Vmin3), la tension Vps1 devient supérieure à Vcc et la tension source-grille Vsg du transistor TP2 est supérieure à sa tension de seuil Vt :

$$Vsg = Vps1-(Vcc-Vt) = Vt + (Vps1-Vcc).$$

Le transistor TP2 devient passant et le signal CS monte vers la tension Vps1, de sorte que le transistor Td se bloque. Le temps de commutation du bloc B1 est rapide de sorte que le temps où la tension Vps1 survoltée par la pompe de charge est en court-circuit avec la tension Vcc est négligeable..

En définitive, et comme indiqué plus haut, le transistor Td contrôlé par le bloc B1 se comporte comme une diode virtuelle idéale, en étant passant quand la tension Vps1 est sensiblement égale à Vcc par valeurs inférieures et en étant bloqué lorsque la tension Vps1 monte sous l'action de la pompe de charge, la tension Vcc étant alors inférieure à Vmin3 (figures 4A, 4B).

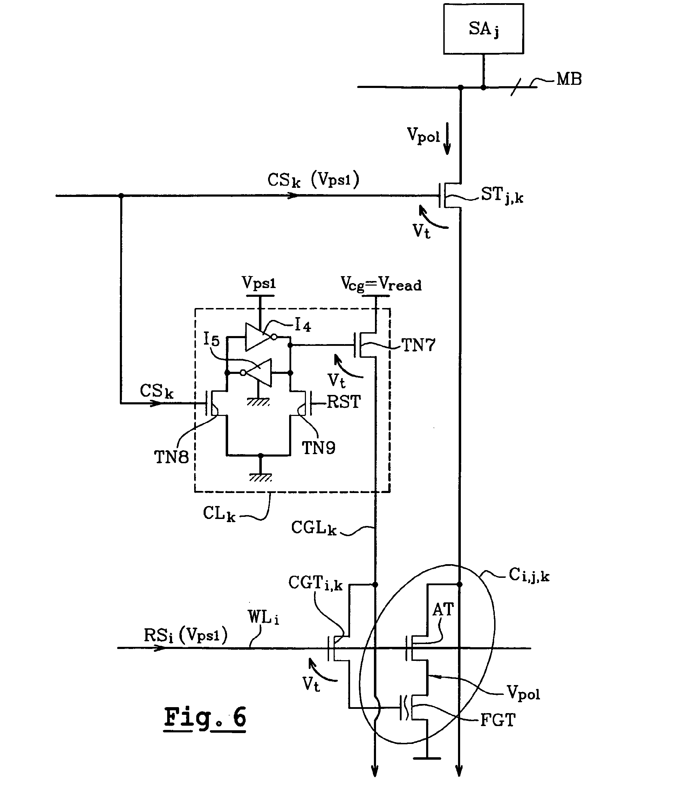

La figure 6 illustre le déroulement du processus de lecture d'une cellule mémoire $C_{i,j,k}$ quand la tension Vps1 est égale à la tension contrôlée Vcont selon l'invention. Un amplificateur de lecture $SA_j$ applique une tension de polarisation Vpol sur une ligne de bit $BL_{i,k}$, par l'intermédiaire du bus de multiplexage MB, d'un transistor de sélection $ST_{j,k}$ et d'un transistor d'accès AT. Le transistor AT reçoit sur sa grille le signal de sélection $RS_i$ égal à Vps1, délivré par le décodeur de ligne (non représenté). De même le transistor de sélection $ST_{j,k}$ reçoit sur sa grille le signal de sélection $CS_k$ égal à Vps délivré par le décodeur de colonne (non représenté). Comme la tension Vps1 est au moins égale sinon supérieure au seuil Vmin2=Vpol+Vt, la tension Vpol est transmise sans atténuation au drain d'un transistor à grille flottante FGT présent dans la cellule mémoire $C_{i,j,k}$.

La tension de contrôle de grille Vcg, égale à Vread, est appliquée sur la grille du transistor FGT via un transistor TN7, une ligne de contrôle de grille CGLk et un transistor de contrôle de grille $CGT_{i,k}$. Le transistor TN7 est un élément d'un verrou de colonne CLk comprenant un moyen de verrouillage formé par deux portes inverseuses I4, I5 tête-bêche alimentées par la tension Vps1. La sortie du moyen de verrouillage est mise à 1 par application du signal de sélection $CS_k$ à un transistor TL2, agencé entre l'entrée du moyen de verrouillage et la masse. Ainsi, la sortie du moyen de verrouillage délivre un signal de grille du transistor TL1 égal à Vps1. Comme la tension Vps1 est au moins égale sinon supérieure au seuil Vmin1=Vread+Vt, la tension Vread est transmise sans atténuation à la ligne de contrôle de grille. De même le transistor $CGT_{i,k}$ reçoit sur sa grille le signal de sélection $RS_i$ égal à Vps1, de sorte que la tension Vread est transmise sans atténuation à la grille du transistor FGT. Lorsque la lecture du transistor est terminée, le verrou $CL_k$ est remis à 0 en appliquant un signal RST sur la grille d'un transistor TN9 agencé entre la sortie du moyen de verrouillage et la masse.

Le contrôle de la tension Vps1 selon la présente invention garantit le bon déroulement du processus de lecture tout en offrant l'avantage de ne déclencher la pompe de charge qu'au moment où cela est vraiment nécessaire, c'est-à-dire lorsque la tension Vcc est inférieure à Vmin3, de sorte que la consommation électrique globale du dispositif PSMC est optimale. Pour une bonne optimisation de la consommation électrique du dispositif PSMC, il est conseillé de choisir le seuil Vmin3 le plus faible possible, la valeur minimale de Vmin3 étant égale au seuil le plus élevé parmi les deux seuils Vmin1, Vmin2.

Il apparaîtra clairement à l'homme de l'art que la présente invention est susceptibles de diverses variantes de réalisation.

En particulier, la prévision d'un circuit superdiode selon l'invention permet de retarder autant que possible le déclenchement de la pompe de charge et d'utiliser au maximum la tension externe Vcc, avant que celle-ci ne devienne inférieure au seuil Vmin3. Toutefois, l'utilisation d'une simple diode présentant à ses bornes une tension Vdiode non nulle peut également être envisagée. Dans ce cas, la pompe de charge se déclenche lorsque la tension Vcc devient inférieure à un seuil Vmin4 = Vmin3 + Vdiode, au lieu de se déclencher lorsque la tension Vcc devient inférieure au seuil Vmin3. La pompe de charge est dans ce cas active lorsque la tension Vcc se trouve comprise entre les seuils Vmin4 et Vmin3, ce qui peut entraîner une consommation de courant sensiblement supérieure dans les applications où la tension Vcc se trouve souvent dans cette fourchette de valeurs.

D'autre part, bien que l'on ait décrit dans ce qui précède un circuit de gestion d'alimentation utilisant avantageusement un seul circuit survolteur pour contrôler la tension d'alimentation interne pendant la lecture de cellules mémoire et pour délivrer la haute tension Vpp pendant l'effacement et la programmation de cellules mémoire, il va de soi qu'un circuit selon l'invention pourrait comprendre deux circuits survolteurs distincts.

Il apparaîtra également à l'homme de l'art que la présente invention est susceptible d'être appliquée à divers types de mémoires, l'architecture de mémoire décrite ci-dessus n'ayant été donnée qu'à titre d'exemple.

**Revendications**

1. Mémoire (MEM2) effaçable et programmable électriquement, comprenant un plan mémoire (MA) comportant des cellules mémoire ($C_{i,j,k}$), et une ligne (20) de distribution d'une tension d'alimentation interne (Vps1, Vcont) reliée d'une part à une borne (21) de réception d'une tension d'alimentation externe (Vcc) et d'autre part à un circuit survolteur (PMP3),
**caractérisée en ce qu**'elle comprend une diode ou un circuit diode (SDC) simulant le fonctionnement d'une diode, reliant la ligne de distribution (20) à la borne de réception (21), et des moyens (REG3) pour déclencher le circuit survolteur (PMP3) lorsque la tension d'alimentation interne (Vps1, Vcont) devient inférieure à un seuil (Vmin3) déterminé, de manière à maintenir la tension d'alimentation interne (Vps1, Vcont) au voisinage du seuil (Vmin3) lorsque la tension d'alimentation externe (Vcc) est trop faible, au moins pendant la lecture de cellules mémoire, la diode ou le circuit diode (SDC) étant alors bloqué.

2. Mémoire selon la revendication 1, dans laquelle le seuil déterminé (Vmin3) est supérieur ou égal à la somme d'une tension (Vread) de lecture de cellule mémoire et d'une tension de seuil (Vt) de transistor MOS.

3. Mémoire selon l'une des revendications 1 et 2, dans laquelle le seuil déterminé (Vmin3) est supérieur ou égal à la somme d'une tension (Vpol) de polarisation de drain d'une cellule mémoire devant être lue et d'une tension de seuil (Vt) de transistor MOS.

4. Mémoire selon l'une des revendications 1 à 3, comprenant un circuit survolteur (PMP3) pour porter la tension d'alimentation interne (Vps1) à une haute tension (Vpp) d'effacement ou de programmation de cellules mémoire, pendant des phases d'effacement ou de programmation de cellules mémoire.

5. Mémoire selon l'une des revendications 1 à 4, comprenant un seul circuit survolteur (PMP3) et un régulateur (REG3) à deux modes de fonctionnement, pour :

    - pendant des phases d'effacement ou de programmation de cellules mémoire, porter la tension d'alimentation interne (Vps1) à une haute tension (Vpp) d'effacement ou de programmation, et
    - au moins pendant des phases de lecture de cellules mémoire, maintenir la tension d'alimentation interne (Vps1, Vcont) au voisinage du seuil (Vmin3) lorsque la tension d'alimentation externe (Vcc) est trop faible.

6. Mémoire selon l'une des revendications 1 à 5 comprenant un décodeur de ligne (RDEC) comportant une borne d'alimentation (T1) connectée à la ligne de distribution (20).

7. Mémoire selon l'une des revendications 1 à 6 comprenant des verrous de sélection de colonne (CLk) et une borne (T3) d'alimentation des verrous de sélection de colonne connectée à la ligne de distribution (20).

8. Mémoire selon l'une des revendications 1 à 7, comprenant des verrous de programmation (PL$_{j,k}$) et une borne (T4) d'alimentation des verrous de programmation connectée à la ligne de distribution (20).

9. Mémoire selon l'une des revendications 1 à 8, comprenant un décodeur de colonne (CDEC) et une borne (T2) d'alimentation du décodeur de colonne qui est reliée d'une part à la ligne de distribution (20) par l'intermédiaire d'un premier interrupteur (SW1) qui est fermé au moins pendant des phases de lecture de cellules mémoire, et est reliée d'autre part à la borne (21) de réception de la tension d'alimentation externe (Vcc) par l'intermédiaire d'un second interrupteur (SW2) qui est fermé lorsque le premier interrupteur (SW1) est ouvert.

10. Mémoire selon l'une des revendications 1 à 9, dans laquelle le circuit diode (SDC) comprend :

    - un interrupteur d'alimentation (Td) à faible chute de tension série dont l'anode est reliée à la borne (21) de réception de la tension d'alimentation externe (Vcc) et la cathode est reliée à la ligne de distribution (20), et
    - des moyens (B1) de commande de l'interrupteur d'alimentation (Td), agencés pour fermer automatiquement l'interrupteur d'alimentation (Td) lorsque la tension d'alimentation interne (Vps1) est supérieure à la tension d'alimentation externe (Vcc).

11. Mémoire selon la revendication 10, dans laquelle les moyens de commande de l'interrupteur comprennent un circuit différentiel (B1) pour comparer la tension d'alimentation externe (Vcc) et la tension d'alimentation interne (Vps1) et délivrer un signal de commande (CS) de l'interrupteur d'alimentation (Td), de manière à ouvrir l'interrupteur d'alimentation lorsque la tension d'alimentation interne (Vps1) est supérieure à la tension d'alimentation externe (Vcc), et à maintenir l'interrupteur d'alimentation fermé lorsque la tension d'alimentation interne est sensiblement égale à la tension d'alimentation externe.

**12.** Mémoire selon la revendication 11, dans laquelle le circuit différentiel (B1) comprend :

- deux branches (TP1/TN1, TP2/TN2) agencées en miroir de courant, comprenant chacune au moins un transistor PMOS (TP1, TP2) en série avec un transistor NMOS (TN1, TN2), une première branche étant polarisée par la tension d'alimentation externe (Vcc) et une seconde branche étant polarisée par la tension d'alimentation interne (Vps1), le signal de commande (CS) de l'interrupteur d'alimentation (Td) étant prélevé sur le drain du transistor PMOS (TP2) de la branche polarisée par la tension d'alimentation interne (Vps1).

**13.** Mémoire selon l'une des revendications 10 à 12, dans laquelle l'interrupteur d'alimentation est un transistor PMOS (Td).

**14.** Mémoire selon l'une des revendications 1 à 13, dans laquelle le circuit survolteur est une pompe de charge (PMP).

**15.** Procédé de gestion d'une tension d'alimentation interne (Vps1) d'une mémoire (MEM2) effaçable et programmable électriquement, comprenant un plan mémoire (MA) comportant des cellules mémoire ($C_{i,j,k}$), et une ligne (20) de distribution de la tension d'alimentation interne (Vps1, Vcont) reliée d'une part à une borne (21) de réception d'une tension d'alimentation externe (Vcc) et d'autre part à un circuit survolteur (PMP3),
**caractérisé en ce qu'**il comprend une étape consistant à relier la ligne de distribution (20) à la borne de réception (21) par l'intermédiaire d'une diode ou d'un circuit diode (SDC) simulant le fonctionnement d'une diode, et une étape d'activation du circuit survolteur (PMP3) lorsque la tension d'alimentation interne (Vps1, Vcont) devient inférieure à un seuil (Vmin3) déterminé, de manière à maintenir la tension d'alimentation interne (Vps1, Vcont) au voisinage du seuil (Vmin3) lorsque la tension d'alimentation externe (Vcc) est trop faible, au moins pendant la lecture de cellules mémoire, la diode ou le circuit diode (SDC) étant alors bloqué.

**16.** Procédé selon la revendication 15, dans lequel le seuil déterminé (Vmin3) est supérieur ou égal à la somme d'une tension (Vread) de lecture de cellule mémoire et d'une tension de seuil (Vt) de transistor MOS.

**17.** Procédé selon l'une des revendications 15 et 16, dans lequel le seuil déterminé (Vmin3) est supérieur ou égal à la somme d'une tension (Vpol) de polarisation de drain d'une cellule mémoire devant être lue et d'une tension de seuil (Vt) de transistor MOS.

**18.** Procédé selon l'une des revendications 15 à 17, dans lequel on prévoit un unique circuit survolteur (PMP3) pour :

- pendant des phases d'effacement ou de programmation de cellules mémoire, porter la tension d'alimentation interne (Vps1) à une haute tension (Vpp) d'effacement ou de programmation, et
- au moins pendant des phases de lecture de cellules mémoire, maintenir la tension d'alimentation interne (Vps1, Vcont) au voisinage du seuil (Vmin3) lorsque la tension d'alimentation externe (Vcc) est trop faible.

**19.** Procédé selon l'une des revendications 15 à 18, appliqué à une mémoire comprenant un décodeur de colonne (CDEC) et une borne (T2) d'alimentation du décodeur de colonne, dans lequel on relie la borne (T2) d'alimentation du décodeur de colonne à la fois à la ligne de distribution (20), par l'intermédiaire d'un premier interrupteur (SW1) qui est fermé au moins pendant des phases de lecture de cellules mémoire, et à la borne (21) de réception de la tension d'alimentation externe (Vcc), par l'intermédiaire d'un second interrupteur (SW2) qui est fermé lorsque le premier interrupteur (SW1) est ouvert.

**20.** Procédé selon l'une des revendications 15 à 19, dans lequel on utilise un circuit diode (SDC) comprenant un interrupteur d'alimentation (Td) à faible chute de tension série dont l'anode est reliée à la borne (21) de réception de la tension d'alimentation externe (Vcc) et la cathode est reliée à la ligne de distribution (20), et des moyens (B1) de commande de l'interrupteur d'alimentation (Td), agencés pour fermer automatiquement l'interrupteur d'alimentation (Td) lorsque la tension d'alimentation interne (Vps1) est supérieure à la tension d'alimentation externe (Vcc).

**Claims**

**1.** Electrically erasable and programmable memory (MEM2), comprising a memory array (MA) comprising memory cells ($C_{i,j,k}$), and a distribution line (20) of an internal supply voltage (Vps1, Vcont) linked firstly to a receiving terminal (21) of an external supply voltage (Vcc) and secondly to a booster circuit (PMP3),
**characterised in that** it comprises a diode or a diode circuit (SDC) simulating the operation of a diode, linking the distribution line (20) to the receiving terminal (21), and means (REG3) for triggering the booster circuit (PMP3) when the internal supply voltage (Vps1, Vcont) becomes lower than a determined threshold (Vmin3), so as to maintain the internal supply voltage (Vps1, Vcont) proximate to the threshold (Vmin3) when the external supply voltage (Vcc) is too low, at least during the reading of memory cells, the diode or the diode circuit (SDC) then being blocked.

2.  Memory according to claim 1, wherein the determined threshold (Vmin3) is higher than or equal to the sum of a memory cell read voltage (Vread) and a MOS transistor threshold voltage (Vt).

3.  Memory according to one of claims 1 and 2, wherein the determined threshold (Vmin3) is higher than or equal to the sum of a drain bias voltage (Vpol) of a memory cell to be read and a MOS transistor threshold voltage (Vt).

4.  Memory according to one of claims 1 to 3, comprising a booster circuit (PMP3) to take the internal supply voltage (Vps1) to a high memory cell erasing or programming voltage (Vpp), during phases of erasing or programming memory cells.

5.  Memory according to one of claims 1 to 4, comprising a single booster circuit (PMP3) and a regulator (REG3) with two operating modes, to:

    - during phases of erasing or programming memory cells, take the internal supply voltage (Vps1) to a high erasing or programming voltage (Vpp), and
    - at least during phases of reading memory cells, maintain the internal supply voltage (Vps1, Vcont) proximate to the threshold (Vmin3) when the external supply voltage (Vcc) is too low.

6.  Memory according to one of claims 1 to 5, comprising a line decoder (RDEC) comprising a supply terminal (T1) connected to the distribution line (20).

7.  Memory according to one of claims 1 to 6, comprising column selection locks (CLk) and a column selection lock supply terminal (T3) connected to the distribution line (20).

8.  Memory according to one of claims 1 to 7, comprising programming locks (PL$_{j,k}$) and a programming lock supply terminal (T4) connected to the distribution line (20).

9.  Memory according to one of claims 1 to 8, comprising a column decoder (CDEC) and a column decoder supply terminal (T2) that is linked firstly to the distribution line (20) through a first switch (SW1) that is off at least during phases of reading memory cells, and is linked secondly to the receiving terminal (21) of the external supply voltage (Vcc) through a second switch (SW2) that is off when the first switch (SW1) is on.

10. Memory according to one of claims 1 to 9, wherein the diode circuit (SDC) comprises:

    - a power switch (Td) with low series voltage drop in which the anode is linked to the receiving terminal (21) of the external supply voltage (Vcc) and the cathode is linked to the distribution line (20), and
    - means (B1) for controlling the power switch (Td), arranged to automatically switch off the power switch (Td) when the internal supply voltage (Vps1) is higher than the external supply voltage (Vcc).

11. Memory according to claim 10, wherein the means for controlling the switch comprise a differential circuit (B1) to compare the external supply voltage (Vcc) and the internal supply voltage (Vps1) and to deliver a control signal (CS) of the power switch (Td), so as to switch on the power switch when the internal supply voltage (Vps1) is higher than the external supply voltage (Vcc), and to maintain the power switch off when the internal supply voltage is substantially equal to the external supply voltage.

12. Memory according to claim 11, wherein the differential circuit (B1) comprises:

    - two branches (TP1/TN1, TP2/TN2) arranged as current mirrors, each comprising at least one PMOS transistor (TP1, TP2) in series with an NMOS transistor (TN1, TN2), a first branch being biased by the external supply voltage (Vcc) and a second branch being biased by the internal supply voltage (Vps1), the control signal (CS) of the power switch (Td) being taken off at the drain of the PMOS transistor (TP2) of the branch biased by the internal supply voltage (Vps1).

**13.** Memory according to one of claims 10 to 12, wherein the power switch is a PMOS transistor (Td).

**14.** Memory according to one of claims 1 to 13, wherein the booster circuit is a charge pump (PMP).

**15.** Method for managing an internal supply voltage (Vps1) of an electrically erasable and programmable memory (MEM2), comprising a memory array (MA) comprising memory cells ($C_{i,j,k}$), and a distribution line (20) of the internal supply voltage (Vps1, Vcont) linked firstly to a receiving terminal (21) of an external supply voltage (Vcc) and secondly to a booster circuit (PMP3),
**characterised in that** it comprises one step of linking the distribution line (20) to the receiving terminal (21) through a diode or a diode circuit (SDC) simulating the operation of a diode, and one step of activating the booster circuit (PMP3) when the internal supply voltage (Vps1, Vcont) becomes lower than a determined threshold (Vmin3), so as to maintain the internal supply voltage (Vps1, Vcont) proximate to the threshold (Vmin3) when the external supply voltage (Vcc) is too low, at least during the reading of memory cells, the diode or the diode circuit (SDC) then being blocked.

**16.** Method according to claim 15, wherein the determined threshold (Vmin3) is higher than or equal to the sum of a memory cell read voltage (Vread) and a MOS transistor threshold voltage (Vt).

**17.** Method according to one of claims 15 and 16, wherein the determined threshold (Vmin3) is higher than or equal to the sum of a drain bias voltage (Vpol) of a memory cell to be read and a MOS transistor threshold voltage (Vt).

**18.** Method according to one of claims 15 to 17, wherein a single booster circuit (PMP3) is provided to:

- during phases of erasing or programming memory cells, take the internal supply voltage (Vps1) to a high erasing or programming voltage (Vpp), and
- at least during phases of reading memory cells, maintain the internal supply voltage (Vps1, Vcont) proximate to the threshold (Vmin3) when the external supply voltage (Vcc) is too low.

**19.** Method according to one of claims 15 to 18, applied to a memory comprising a column decoder (CDEC) and a supply terminal (T2) of the column decoder, in which the supply terminal (T2) of the column decoder is linked both to the distribution line (20), through a first switch (SW1) that is off at least during phases of reading memory cells, and to the receiving terminal (21) of the external supply voltage (Vcc), through a second switch (SW2) that is off when the first switch (SW1) is on.

**20.** Method according to one of claims 15 to 19, wherein a diode circuit (SDC) is used comprising a power switch (Td) with low series voltage drop wherein the anode is linked to the receiving terminal (21) of the external supply voltage (Vcc) and the cathode is linked to the distribution line (20), and means (B1) for controlling the power switch (Td), arranged to automatically switch off the power switch (Td) when the internal supply voltage (Vps1) is higher than the external supply voltage (Vcc).

**Patentansprüche**

**1.** Elektronisch löschbarer und programmierbarer Speicher (MEM2), umfassend eine Speicherzellen ($C_{i,j,k}$) enthaltende Speicherebene (MA) und eine Leitung (20) zum Verteilen interner Versorgungsspannung (Vps1, Vcont), die einerseits mit einem Anschluss (21) zum Empfangen einer externen Versorgungsspannung (Vcc) und andererseits mit einer Zusatzspannungsschaltung (PMP3) verbunden ist,
**dadurch gekennzeichnet, dass** er eine Diode oder eine die Funktion einer Diode simulierende Diodenschaltung (SDC), die die Versorgungsleitung (20) mit dem Empfangsanschluss (21) verbindet, und Mittel (REG3) enthält, die die Zusatzspannungsschaltung (PMP3) auslösen, wenn die interne Versorgungsspannung (Vps1, Vcont) unter eine bestimmte Schwelle (Vmin3) fällt, so dass die interne Versorgungsspannung (Vps1, Vcont) nahe der Schwelle (Vmin3) gehalten wird, wenn die externe Versorgungsspannung (Vcc) zu gering ist, mindestens während des Lesens einer Speicherzelle, wobei die Diode oder die Diodenschaltung (SDC) blockiert sind.

**2.** Speicher nach Anspruch 1, wobei die bestimmte Schwelle (Vmin3) größer oder gleich der Summe aus einer Lesespannung (Vread) zum Lesen der Speicherzelle und einer Schwellspannung (Vt) des MOS-Transistors ist.

**3.** Speicher nach Anspruch 1 oder 2, wobei die bestimmte Schwelle (Vmin3) größer oder gleich der Summe aus einer Spannung (Vpol) zum Polarisieren der Drainelektrode einer Speicherzelle vor ihrem Lesen und einer Schwellspannung (Vt) des MOS-Transistors ist.

4. Speicher nach einem der Ansprüche 1 bis 3, umfassend eine Zusatzspannungsschaltung (PMP3), mit der die interne Versorgungsspannung (Vps1) während Phasen zum Löschen oder Programmieren der Speicherzellen auf eine Hochspannung (Vpp) gebracht wird, um die Speicherzellen zu löschen oder zu programmieren.

5. Speicher nach einem der Ansprüche 1 bis 4, umfassend eine Zusatzspannungsschaltungsschwelle (PMP3) und einen Regulator (REG3) mit zwei Funktionsmodi, um:

   - die interne Versorgungsspannung (Vps1) während der Phasen zum Löschen oder Programmieren der Speicherzellen auf eine Hochspannung (Vpp) zum Löschen oder Programmieren der Speicherzellen zu bringen, und
   - mindestens während der Lesephasen der Speicherzellen die interne Versorgungsspannung (Vps1, Vcont) nahe der Schwelle (Vmin3) zu halten, wenn die externe Versorgungsspannung (Vcc) zu gering ist.

6. Speicher nach einem der Ansprüche 1 bis 5, umfassend einen Leitungsdecodierer (RDEC), der einen mit der Versorgungsleitung (20) verbundenen Versorgungsanschluss (T1) aufweist.

7. Speicher nach einem der Ansprüche 1 bis 6, umfassend Spaltenauswahlriegel (CLk) und einen Versorgungsanschluss (T3) der Spaltenauswahlriegel (CLk), der mit der Versorgungsleitung (20) verbunden ist.

8. Speicher nach einem der Ansprüche 1 bis 7, umfassend Programmierungsriegel (PL$_{j,k}$) und einen Versorgungsanschluss (T4) der Programmierungsriegel, der mit der Versorgungsleitung (20) verbunden ist.

9. Speicher nach einem der Ansprüche 1 bis 8, umfassend einen Spaltendecodierer (CDEC) und einen Versorgungsanschluss (T2) des Spaltendecodierers, der einerseits über einen mindestens während der Lesephasen der Speicherzellen geschlossenen ersten Schalter (SW1) mit der Versorgungsleitung (20) verbunden ist, und andererseits über einen zweiten Schalter (SW2), der geschlossen ist, wenn der erste Schalter (SW1) geöffnet ist, mit dem Empfangsanschluss (21) der externen Versorgungsspannung (Vcc) verbunden ist.

10. Speicher nach einem der Ansprüche 1 bis 9, wobei die Diodenschaltung (SDC) Folgendes umfasst:

    - Versorgungsschalter (Td) mit geringem Spannungsabfall, dessen Anode mit dem Empfangsanschluss (21) der externen Versorgungsspannung (Vcc) und dessen Kathode mit der Versorgungsleitung (20) verbunden ist, und
    - Mittel (B1) zum Ausgeben von Befehlen an den Versorgungsschalter (Td), die so ausgelegt sind, dass sie den Versorgungsschalter (Td) automatisch schließen, wenn die interne Versorgungsspannung (Vps1) über der externen Versorgungsspannung (Vcc) liegt.

11. Speicher nach Anspruch 10, wobei die Mittel zum Ausgeben von Befehlen an den Schalter eine Differenzialschaltung (B1) zum Vergleichen der externen Versorgungsspannung (Vcc) und der internen-Versorgungsspannung (Vps1) und zum Liefern eines Befehlssignals (CS) des Versorgungsschalters (Td) umfassen, so dass sich der Versorgungsschalter öffnet, wenn die interne Versorgungsspannung (Vps1) über der externen Versorgungsspannung (Vcc) liegt, und so dass der Versorgungsschalter geschlossen bleibt, wenn die interne Versorgungsspannung im Wesentlichen gleich der externen Versorgungsspannung ist.

12. Speicher nach Anspruch 11, wobei die Differenzialschaltung (B1) Folgendes umfasst:

    - zwei Zweige (TP1/TN1, TP2/TN2), die so ausgelegt sind, dass sie den Strom spiegeln, wobei jeder mindestens einen in Serie mit einem NMOS-Transistor (TN1, TN2) geschalteten PMOS-Transistor (TP1, TP2) umfasst, wobei ein erster Zweig durch die externe Versorgungsspannung (Vcc) polarisiert ist und ein zweiter Zweig durch die interne Versorgungsspannung (Vps1) polarisiert ist, wobei das Befehlssignal (CS) des Versorgungsschalters (Td) über die Drainelektrode des PMOS-Transistors (TP2) des durch die interne Versorgungsspannung (Vps1) polarisierten Zweigs abgeht.

13. Speicher nach einem der Ansprüche 10 bis 12, wobei es sich bei dem Versorgungsschalter um einen PMOS-Transistor (Td) handelt.

EP 1 365 418 B1

**14.** Speicher nach einem der Ansprüche 1 bis 13, wobei es sich bei der Zusatzspannungsschaltung um eine Ladepumpe (PMP) handelt.

**15.** Verfahren zum Zuführen einer internen Versorgungsspannung (Vps1) eines elektronisch löschbaren und programmierbaren Speichers (MEM2), umfassend eine Speicherzellen (C$_{i, j, k}$) enthaltende Speicherebene (MA) und eine Leitung (20) zum Verteilen der internen Versorgungsspannung (Vps1, Vcont), die einerseits mit einem Anschluss (21) zum Empfangen einer externen Versorgungsspannung (Vcc) und andererseits mit einer Zusatzspannungsschaltung (PMP3) verbunden ist,
**dadurch gekennzeichnet, dass** es einen Schritt des Verbindens der Versorgungsleitung (20) mit dem Empfangsanschluss (21) über eine Diode oder eine die Funktion einer Diode simulierende Diodenschaltung (SDC) und einen Schritt der Aktivierung der Zusatzspannungsschaltung (PMP3) umfasst, wenn die interne Versorgungsspannung (Vps1, Vcont) unter eine bestimmte Schwelle (Vmin3) fällt, so dass die interne Versorgungsspannung (Vps1, Vcont) nahe der Schwelle (Vmin3) gehalten wird, wenn die externe Versorgungsspannung (Vcc) zu gering ist, mindestens während des Lesens einer Speicherzelle, wobei die Diode oder die Diodenschaltung (SDC) blockiert sind.

**16.** Verfahren nach Anspruch 15, wobei die bestimmte Schwelle (Vmin3) größer oder gleich der Summe aus einer Lesespannung (Vread) zum Lesen der Speicherzelle und einer Schwellspannung (Vt) des MOS-Transistors ist.

**17.** Verfahren nach Anspruch 15 oder 16, wobei die bestimmte Schwelle (Vmin3) größer oder gleich der Summe aus einer Spannung (Vpol) zum Polarisieren der Drainelektrode einer Speicherzelle vor ihrem Lesen und einer Schwellspannung (Vt) des MOS-Transistors ist.

**18.** Verfahren nach einem der Ansprüche 15 bis 17, wobei eine einzige Zusatzspannungsschaltung (PMP3) vorgesehen ist, um:

- die interne Versorgungsspannung (Vps1) während der Phasen zum Löschen oder Programmieren der Speicherzellen auf eine Hochspannung (Vpp) zum Löschen oder Programmieren der Speicherzellen zu bringen, und
- mindestens während der Lesephasen der Speicherzellen die interne Versorgungsspannung (Vps1, Vcont) nahe der Schwelle (Vmin3) zu halten, wenn die externe Versorgungsspannung (Vcc) zu gering ist.

**19.** Verfahren nach einem der Ansprüche 15 bis 18, das auf einen Speicher angewendet wird, der einen Spaltendecodierer (CDEC) und einen Versorgungsanschluss (T2) des Spaltendecodierers umfasst, wobei der Versorgungsanschluss (T2) zugleich über einen mindestens während der Lesephasen der Speicherzellen geschlossenen ersten Schalter (SW1) mit der Versorgungsleitung (20) verbunden ist, und über einen zweiten Schalter (SW2), der geschlossen ist, wenn der erste Schalter (SW1) geöffnet ist, mit dem Empfangsanschluss der externen Versorgungsspannung (Vcc) verbunden ist.

**20.** Verfahren nach einem der Ansprüche 15 bis 19, wobei eine Diodenschaltung (SDC) eingesetzt wird, die einen Versorgungsschalter (Td) mit geringem Spannungsabfall, dessen Anode mit dem Empfangsanschluss (21) der externen Versorgungsspannung (Vcc) und dessen Kathode mit der Versorgungsleitung (20) verbunden ist, und Mittel (B1) zum Ausgeben von Befehlen an den Versorgungsschalter (Td) umfasst, die so ausgelegt sind, dass sie den Versorgungsschalter (Td) automatisch schließen, wenn die interne Versorgungsspannung (Vps1) über der externen Versorgungsspannung (Vcc) liegt.

**Fig. 1A**

**Fig. 1B**

**Fig. 1C**

MEM2

Vcc    Vps1
21 ⌐              OUT1
        PSMC
OUT3    OUT2
↓        ↓
Vcg     Vps2

Vps2
⌐ T₂
CDEC

Vps1
⌐ T₁
RDEC

CSₖ

RSᵢ

SA

MB

CSC

Vps1
⌐ T₄
PLC

Vps1
Vcg
T₃
CLC

MA

**Fig. 2**

PSMC

Vcc
⌐ 21
SDC

Vcc
PMP₃

ON/OFF

REG3

S1

RAMPGEN

20

(OUT1)
→ Vps1

CGGEN

(OUT3)
→ Vcg

Vps1

Vcc

I₁                    I₂
S₂                    S̄₂              SW2

SPSMC

SW1

(OUT2)
→ Vps2

**Fig. 3**

Vcc

(PMP3 OFF)

(PMP3 ON/OFF)

Vmin3

**Fig. 4A**

Vps1(Vcont)

Vcc

Vmin3

**Fig. 4B**

SDC

ENABLE

Vcc

Vcc

CS

Vcc 21

Td

TP3

Vps1

20

TP1

I₁

I₂ CS

**Fig. 5**

Vref

TN1

TN2

B1

TN3

$\overline{ENABLE}$

TN5

I₃

ENABLE

**Fig. 6**